# EUROPEAN PATENT APPLICATION

(11) **EP 4 129 679 A1**
(43) Date of publication of application: **08.02.2023**
(21) Application number: 22183932.7
(22) Date of filing: 08.07.2022
(51) Int. Cl.: B32B 37/10

(54) **LAMINATING METHOD AND DEVICE FOR G2G SOLAR MODULE**

(30) Priority: 04.08.2021 KR 20210102351
(71) Applicant: Korea Institute of Energy Research, Daejeon 34129 (KR)
(72) Inventor: EO, Young Joo, 34016 Daejeon (KR); YUN, Jae Ho, 30153 Sejong-si (KR); AHN, Se Jin, 34083 Daejeon (KR); CHO, A Ra, 34127 Daejeon (KR); YOO, Jin Su, 34127 Daejeon (KR); CHO, Jun Sik, 34085 Daejeon (KR); AHN, Seong Kyu, 35210 Daejeon (KR); PARK, Joo Hyung, 34090 Daejeon (KR); SHIN, Dong Hyeop, 34127 Daejeon (KR); JEONG, In Young, 28292 Chungcheongbuk-do (KR); SONG, Soo Min, 34120 Daejeon (KR); LEE, Sang Min, 34082 Daejeon (KR); LEE, Ah Reum, 34116 Daejeon (KR); HWANG, In Chan, 34116 Daejeon (KR); KIM, Ki Hwan, 34120 Daejeon (KR); GWAK, Ji Hye, 34083 Daejeon (KR)
(74) Representative: Brevalex

(57) **Abstract**

A laminating method that presses by expanding a membrane positioned over a G2G solar module having a front glass and a back glass while manufacturing the G2G solar module. The present invention may prevent damage to the edge of the glass due to the expanding membrane by installing the support frame around the module while laminating the G2G solar module. It is possible to prevent a reduction in durability due to warping at the edge of the front glass and back glass although no damage is caused during the laminating process (figure 1).

## Description

### BACKGROUND

### Field

The present invention relates to a method for laminating a solar module that performs photovoltaic power generation and, more specifically, to a method for laminating a glass to glass (G2G) solar module having two opposite glasses.

### Description of Related Art

In general, a solar cell is a photoelectric conversion device that converts light energy into electrical energy and collects the electrical energy generated as charges are generated or separated at the PN junction interface and supplies it to the outside.

Since such a solar cell is used in an external environment to absorb light energy, the solar cell in which the photoelectric conversion is performed and the conducting wire that transfers electricity may deteriorate, resulting in a gradual decrease in power generation efficiency. To address such issue, the solar cell is protected through packaging, which wraps it with several materials, rather than being used as it is, and the resultant structure is referred to as a solar module. Each of the plurality of solar cell devices installed in the solar cell module is referred to as a solar cell to distinguish from the solar module.

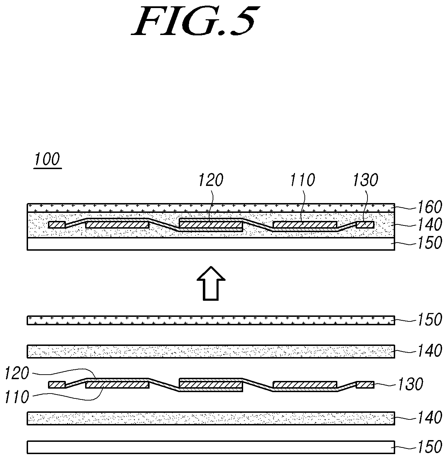

FIG. 5 is a view illustrating a configuration of a solar module and a laminating process.

As described above, the solar module 100 includes a plurality of solar cells 110. The solar module 100 include a plurality of strings each including a plurality of solar cells 110 electrically connected with each other by lead lines 120 and electrodes 130 electrically connecting the strings, which are sealed by an encapsulant 140 and further include a front glass 150 and a back sheet 160 respectively on the upper and lower surfaces.

The solar module 100 is manufactured by a laminating process that places the encapsulant 140, the front glass 150, and the back sheet 160 on the two opposite surfaces of the prepared strings, stack them, and then seal the strings, the front glass 150 and the back sheet 160 with the encapsulant 140 by heating and pressing them.

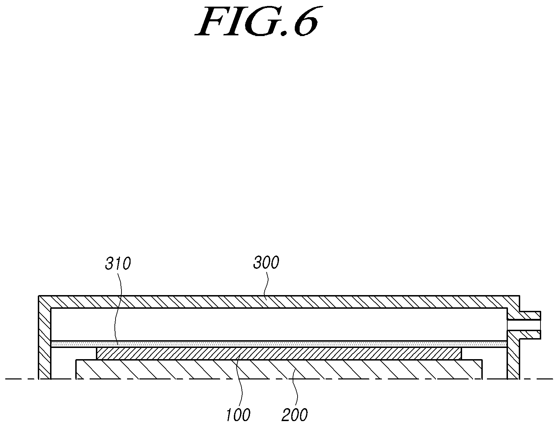

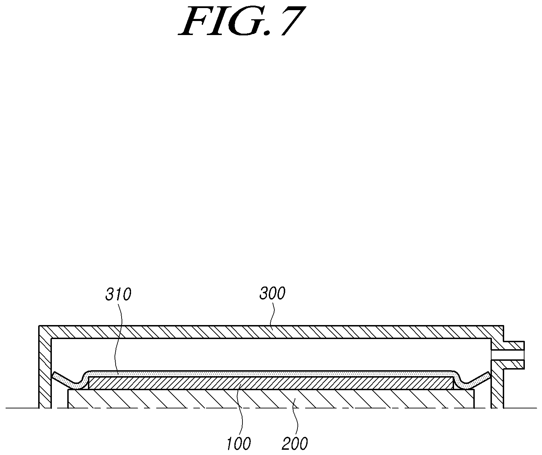

FIGS. 6 and 7 are views illustrating a conventional solar module laminating device and laminating process.

The laminating process heats a sheet-like stacked encapsulant to cause a chemical reaction while pressing it down to fully fill the surroundings of the strings. The solar module laminating device has a heating means 200 disposed under the solar module and a pressing means 300 disposed over the solar module. Specifically, the solar module 100 is placed on the heating means, with the front glass facing downward, and the pressing means 300 presses down the back sheet. To prevent gaps or pores while the encapsulant surrounds the string, the solar module 100 should be heated and pressed in a vacuum or pressure-down state. Conventionally, the pressing means 300 is configured to press the solar module 100 by expanding a flexible membrane 310 (or diaphragm) not to affect the vacuum or pressure-down state of the solar module 100 positioned thereunder (see Korean Patent Application Publication Nos. 10-2017-0131179 and 10-2008-0016473).

Recently increasing is the demand for double-sided modules that may increase power generation efficiency and be installed in more places. The solar module which includes the front glass and the back sheet, glass-to-back sheet (G2B) solar module, as shown in FIG. 5 generates power only with the light incident on the front glass and is thus referred to as a single-sided module and has a limitation in installation place due to the opaque back sheet. A double-sided module is a solar module configured to be able to use both the light incident on the front surface and the light incident on the back surface. There is increasing demand for glass-to-glass (G2G) solar modules that have glasses on the front and back surfaces. However, the G2G solar module may be vulnerable to damage during or after the laminating process.

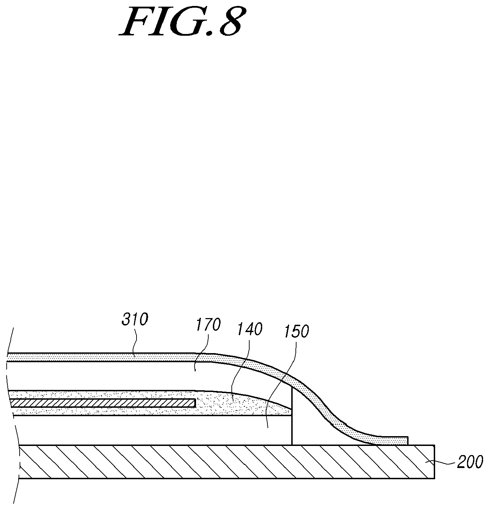

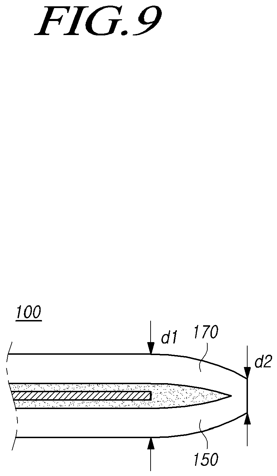

FIG. 8 is a view illustrating an example of applying a conventional laminating method to a G2G solar module. FIG. 9 is a view illustrating an issue with a G2G solar module manufactured by a conventional laminating method.

If a G2G solar module is formed by a conventional laminating device as described in connection with FIGS. 6 and 7, the encapsulant 140 may leak out through the edge of a back glass 170 pressed by the membrane 310, so that the edge of the back glass 170 may be overly warped. Thus, the back glass 170 may be broken during the laminating process. Although breakage during the laminating process may be avoided, the front glass 150 and the back glass 170 of the manufactured solar module 100 may be warped at the edges. While the solar module 100 is used, the front glass 150 or the back glass 170 may easily be broken. Thus, the lifespan of such solar module 100 is reduced.

Therefore, a need exists for a novel laminating method and device for G2G solar modules which have double-sided glasses.

### [PRIOR TECHNICAL DOCUMENTS]

### [PATENT DOCUMENTS]

Korean Patent Application Publication No. 10-2017-0131179
Korean Patent Application Publication No. 10-2008-0016473

### BRIEF SUMMARY

To address the foregoing issues with the conventional art, the present invention aims to provide a novel laminating method and device for G2G solar modules which have double-sided glasses.

To achieve the foregoing objectives, according to an embodiment of the present invention, there is provided a laminating method that presses by expanding a membrane positioned over a G2G solar module having a front glass and a back glass while manufacturing the G2G solar module. The laminating method presses by expanding the membrane with at least one support frame at at least one edge of the G2G solar module.

Preferably, the at least one support frame is installed at all of the four edges of the G2G solar module.

A height of the support frame may be equal to or larger than a sum of thicknesses of the front glass and the back glass used for the G2G solar module.

Preferably, a height of the support frame is equal to or larger than a thickness of the G2G solar module.

Preferably, a height of the support frame is 1mm larger than a sum of thicknesses of the front glass and the back glass used for the G2G solar module.

More preferably, a height of the support frame is 2mm larger than a sum of thicknesses of the front glass and the back glass used for the G2G solar module.

Preferably, a gap between the support frame and the edge of the G2G solar module is 4mm or less.

According to an embodiment of the present invention, a laminating device for a G2G solar module having a front glass and a back glass comprises a heating means for heating the G2G solar module, a pressing means positioned over the G2G solar module and having a membrane expanding downward to press the G2G solar module, and at least one support frame installed around the G2G solar module.

Preferably, the at least one support frame is installed at all of the four edges of the G2G solar module.

A height of the support frame may be equal to or larger than a sum of thicknesses of the front glass and the back glass used for the G2G solar module.

Preferably, a height of the support frame is equal to or larger than a thickness of the G2G solar module.

Preferably, a height of the support frame is 1mm larger than a sum of thicknesses of the front glass and the back glass used for the G2G solar module.

More preferably, a height of the support frame is 2mm larger than a sum of thicknesses of the front glass and the back glass used for the G2G solar module.

Preferably, a gap between the support frame and the edge of the G2G solar module is 4mm or less.

The laminating device may further comprise a feeder for transporting the G2G solar module to a laminating position and a support frame moving means to move the support frame not to disturb transportation of the G2G solar module in a path where the G2G solar module is transported by the feeder.

The laminating device may further comprise a discharger for discharging the G2G solar module from the laminating position to the outside and a support frame moving means for moving the support frame not to disturb transportation of the G2G solar module in a path where the G2G solar module is transported by the discharger. FIG. 5

In the G2G solar module is manufactured by the above-described method, the gap between the front glass and the back glass at the edge may be properly maintained even without applying a separate frame structure to the solar module, so that it is possible to prevent damage due to warping at the edge.

The present invention may prevent damage to the edge of the glass due to the expanding membrane by installing the support frame around the module while laminating the G2G solar module.

It is possible to prevent a reduction in durability due to warping at the edge of the front glass and back glass although no damage is caused during the laminating process.

### DESCRIPTION OF DRAWINGS

The above and other objects, features, and advantages of the present disclosure will be more clearly understood from the following detailed description, taken in conjunction with the accompanying drawings, in which:
FIG. 1 is a cross-sectional view illustrating an example of applying a laminating method to a G2G solar module according to the present invention;
FIGS. 2 and 3 are cross-sectional views illustrating an experiment performed to derive an appropriate height of a support frame in a laminating method of a G2G solar module according to the present invention;
FIG. 4 is a photo illustrating a laminating device having a support frame according to embodiments of the disclosure;
FIG. 5 is a view illustrating a configuration of a solar module and a laminating process;
FIGS. 6 and 7 are views illustrating a conventional solar module laminating device and laminating process;
FIG. 8 is a view illustrating an example of applying a conventional laminating method to a G2G solar module; and
FIG. 9 is a view illustrating an issue with a G2G solar module manufactured by a conventional laminating method.

### DETAILED DESCRIPTION

Hereinafter, embodiments of the present invention are described in detail with reference to the accompanying drawings.

However, the embodiments of the present invention may be modified into various other forms, and the scope of the present invention is not limited to the embodiments described below. The shapes and sizes of elements in the drawings may be exaggerated for clearer description. The same reference denotations may be used to refer to the same elements throughout the specification and the drawings.

Throughout the specification, when an element is "connected" with another element, the element may be "directly connected" with the other element, or the element may be "electrically connected" with the other element via an intervening element. When an element "includes" another element, the element may further include the other element, rather excluding the other element, unless particularly stated otherwise.

The terms "first" and "second" are used to distinguish one component from another, and the scope of the disclosure should not be limited thereby. For example, a first component may be denoted a second component, and vice versa without departing from the scope of the present disclosure.

The present invention relates to a method for manufacturing a G2G solar module having double-sided glasses and including solar cells sealed with an encapsulant. The present invention may be applied to any G2G solar module having double-sided glasses, irrespective of the type of the solar cell or the type or internal structure of the encapsulant.

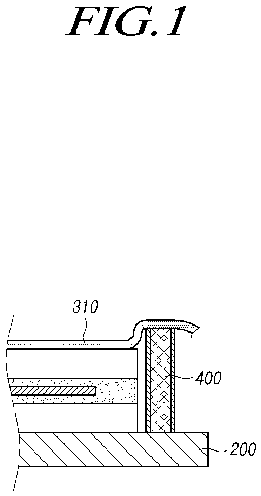

FIG. 1 is a cross-sectional view illustrating an example of applying a laminating method to a G2G solar module according to the present invention.

The laminating method for a G2G solar module according to the present invention performs a laminating process, with a support frame 400 placed on a side of the solar module, in applying a laminating method that presses the solar module by expanding the membrane 310 positioned over the solar module.

Therefore, the conventional method and device applied to laminating of a G2G solar module may be applicable to the present invention without limitations, in such an extent as not to impair the feature of adding the support frame 400.

Installing a heating means 200 under the G2G solar module is substantially the same as that of the conventional laminating method and device, and the configuration of the heating means used in the conventional laminating method and device may be applied as it is.

It is preferable to install four support frames 400 to protect the four edges of the G2G solar module. Since the support frames may be an obstacle to transporting, to the laminating position, and discharging the G2G solar module, one or two opposite edges of the G2G solar module may be emptied if necessary. However, the edge without a support frame may be warped regardless of installation of support frames on the other edges, by the nature of the membrane method and device which expands and presses the flexible membrane 310. Use of less than four support frames provides more protection against warping or damage than when no support frame is used, but has a higher chance of damage than when four support frames are used. Thus, caution should be used in using less than four support frames. To prevent the support frames 400 from disturbing the movement of the G2G solar module, the support frames 400 may be configured to be movable. When the G2G solar module is moved to the laminating position, one or more support frames positioned in the moving path of the G2G solar module may be moved up or aside to give a space for movement of the G2G solar module and, before the laminating method proceeds, are back to their original positions. To that end, the laminating device having a feeder which transports the G2G solar module to the laminating position through the bottom may have a support frame moving means for moving the support frame positioned in the path where the G2G solar module is transported through the feeder. The laminating device having a discharger which discharges the G2G solar module from the laminating position to the outside may have a support frame moving means for moving the support frame positioned in the path where the G2G solar module is transported through the feeder.

The support frame 400 is configured to have a rectangular cross section to facilitate its placement and dispersion of the pressure from the membrane 310, but is not limited thereto.

Preferably, the support frame 400 may be formed of a material selected to, or be surface-treated to, be easily detached from the encapsulant used in the G2G solar module. For example, the support frame may be formed of metal, e.g., aluminum (Al), which may withstand pressure, and be surface-treated with Teflon or have a Teflon sheet attached thereto, to prevent the ethylene vinyl acetate (EVA) encapsulant from sticking thereto. The material of the support frame and the surface treatment method may vary depending on, e.g., the pressure and the type of the encapsulant in the laminating process.

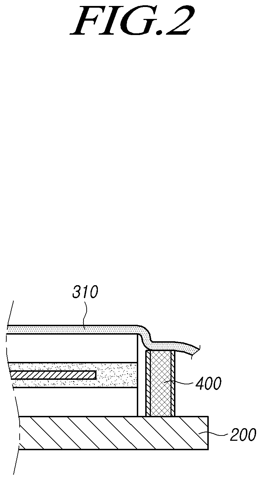

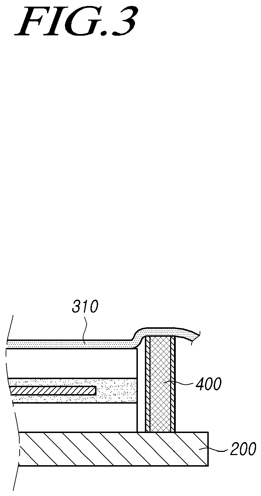

FIGS. 2 and 3 are cross-sectional views illustrating an experiment performed to derive an appropriate height of a support frame in a laminating method of a G2G solar module according to the present invention.

FIG. 2 illustrates an example where the height of the support frame 400 is smaller than the thickness of the G2G solar module. FIG. 3 illustrates an example in which the height of the support frame 400 is substantially the same as the thickness of the G2G solar module. FIG. 1 illustrates an example in which the height of the support frame 400 is larger than the thickness of the G2G solar module.

To derive an appropriate height of the support frame in the laminating method for the G2G solar module according to the disclosure, laminating was performed while changing the height of the support frame 400.

As the front glass and the back glass, 5mm-thick tempered glasses were used, and two EVA sheets were placed on two opposite surfaces of strings including solar cells connected to each other, forming a front/back dual EVA structure. The front glass and the back glass measured 1400mmX700mm. Laminating was performed two times on each of the support frames 400 which have different height, such as 8mm, 10mm, and 12mm. The laminating process was performed at 140 □ for 400 seconds after vacuum evacuation for 250 seconds.

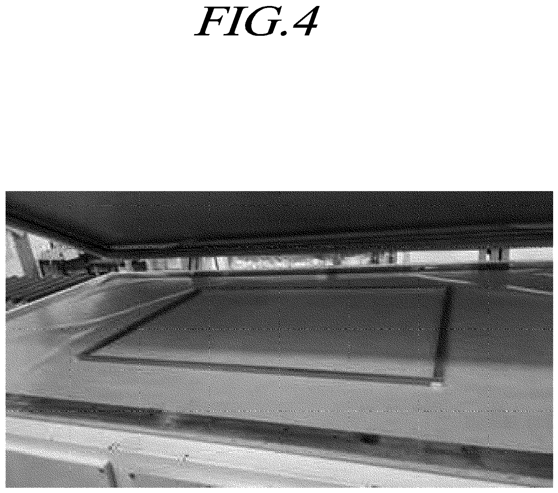

FIG. 4 is a photo illustrating a laminating device having a support frame according to embodiments of the disclosure.

With the device of FIG. 4, the height of the support frame is changed to 8mm, 10mm, and 12mm, and the result was checked.

The results revealed that when the 8mm-high support frame was used, cracks started at an edge and spread to the entire glass in the first laminating process while cracks were caused only in a portion of an edge in the second laminating process.

When the 10mm-high support frame was used, no cracks or damage occurred in both the first and second laminating processes, but bubbles were formed at an edge.

When the 12mm-high support frame were used, neither cracks nor bubbles occurred in both the first and second laminating processes.

The 8.0mm-high support frame, which is lower in height than 10mm, the sum of the thicknesses of the front glass and the back glass, mostly has cracks and is thus inappropriate to use.

Each EVA sheet is 500µm thick, the solar cell is 200µm thick, and the lead line is 150µm thick. Thus, the thickness of the stack before laminating is about 1.5mm. However, the EVA sheets are spread and compressed as the laminating process proceeds, so that the gap between the front glass and the back glass is about 1.0mm.

Since the EVA sheets are relatively thin as compared with the front glass and the back glass, the inventors expected that damage could be prevented with a support frame having a height of 10mm which is the sum of the thicknesses of the front glass and the back glass.

The second experiment was conducted with a support frame having a height of 10mm, the sum of the thicknesses of the front glass and the back glass. As the inventors expected, when the 10mm-high support frame was used, the glasses were not damaged, but bubbles were formed at the edge, degrading quality. However, no issues occurred in additional repeated laminating processes, which appeared to come from the fact that the gap between the front glass and the back glass could not be fixed to a specific value in the laminating processes.

In the last experiment, laminating was conducted using a support frame having a height of 12mm which is larger than the thickness of the solar module after laminating (the sum of 10, which is the total thickness of the front glass and the back glass, and about 1.0mm which is the gap between the front glass and the back glass). As described above, since the gap between the front glass and the back glass is difficult to perfectly adjust, a support frame which is 12mm high larger than 11mm which is the expected thickness of the solar module was used and, as expected, no damage or edge bubbles occurred when the 12mm-highs first was used.

From the results, the height of the support frame should be larger than the thicknesses of the front glass and the back glass used in the G2G solar module, or at least equal. Preferably, the height of the support frame should be equal to or larger than the thickness of the G2G solar module. In this case, the thickness of the G2G solar module means the thickness of the final module (as shown at the top of FIG. 5) completed after laminating. Given that the gap between the front glass and the back glass of the G2G solar module is about 1mm, it is preferable that the support frame is 1mm higher than the thicknesses of the front glass and the back glass used for the G2G solar module. Considering that the gap between the front glass and the back glass may be larger than 1mm, it is preferable that the support frame is 2mm higher than the thicknesses of the front glass and the back glass used for the G2G solar module.

The gap between the G2G solar module and the support frame in the laminating process may be adjusted within a range in which the edges of the glasses are not warped when excessively pressed by the membrane. If the gap between the G2G solar module and the support frame is too large, the effects of the support frame are not achieved, so that it is preferable to adjust the gap not to exceed at least 4mm. Specifically, the gap between the G2G solar module and the support frame may be adjusted in various manners considering, e.g., the characteristics of the membrane and the height of the support frame.

In the G2G solar module laminated by the above-described method and device, the gap between the front glass and the back glass at the edge may be properly maintained even without applying a separate frame structure to the solar module, so that it is possible to prevent damage due to warping at the edge.

While the present invention has been described in connection with embodiments, it will be appreciated by one of ordinary skill in the art that various changes may be made thereto without departing from the technical spirit of the present invention. The scope of the present invention should be construed by the following claims, and all technical spirits within equivalents thereof should be interpreted to belong to the scope of the present invention.

### Legend of Reference Numbers

| | | | |
|---|---|---|---|
| 100: | solar module | 110: | solar cells |
| 120: | lead lines | 130: | electrodes |
| 140: | encapsulant | 150: | front glass |
| 160: | back sheet | 170: | back glass |
| 200: | heating means | 300: | pressing means |
| 310: | membrane | 400: | support frame |

### STATEMENT REGARDING GOVERNMENT-SPONSORED RESEARCH OR DEVELOPMENT

Project Serial No.: 1425145050
Project No.: S3026817
Ministry: Ministry of SMEs and Startups
Managing Agency: Korea Technology & Information Promotion Agency for SMEs
Research program title: Small and Medium Business Support Leading Research Institution Cooperative Technology Development Project (R&D)
Research project title: Development of high-aesthetic color BIPV module manufacturing technology
Contribution rate: 1/3

### Organization performing the project Korea Energy Research Institute

Project period: 2020.11.01. to 2021.10.31.
Project Serial No.: 1711128276
Project No.: 2016M1A2A2936753
Ministry: Ministry of Science and ICT
Managing Agency: National Research Foundation of Korea
Research program title: Basic source technology development task for responding to climate change
Research project title: Development of high-efficiency flexible CIGS thin film solar cell based on R2R process applied to polymer substrate
Contribution rate: 1/3

### Organization performing the project Korea Energy Research Institute

Project period: 2016.11.01. to 2021.10.31(2021.03.01. to 2021.10.31.)
Project No.: C1-2403
Ministry: Ministry of Science and ICT
Managing Agency: Korea Energy Research Institute
Research program title: Basic program
Research project title: Development of non-silicon-based multi-junction flexible solar cell
Contribution rate: 1/3

### Organization performing the project Korea Energy Research Institute

Project period: 2021.01.01. to 2023.12.31. (2021.01.01.to 2021.12.31.)

## Claims

1. A laminating method of pressing by expanding a membrane (310) positioned over a glass-to-glass (G2G) solar module having a front glass (150) and a back glass (160), the laminating method comprising:
pressing by expanding the membrane, with at least one support frame (400) installed at at least one of four edges of the G2G solar module.

2. The laminating method of claim 1, wherein the at least one support frame (400) is installed at all of the four edges of the G2G solar module.

3. The laminating method of claim 1, wherein a height of the support frame (400) is equal to or larger than a sum of thicknesses of the front glass and the back glass used for the G2G solar module.

4. The laminating method of claim 1, wherein a height of the support frame (400) is equal to or larger than a thickness of the G2G solar module.

5. The laminating method of claim 1, where a height of the support frame (400) is 1mm larger than a sum of thicknesses of the front glass and the back glass used for the G2G solar module.

6. The laminating method of claim 1, where a height of the support frame (400) is 2mm larger than a sum of thicknesses of the front glass and the back glass used for the G2G solar module.

7. The laminating method of claim 1, wherein a gap between the support frame (400) and the edge of the G2G solar module is 4mm or less.

8. A laminating device for a G2G solar module having a front glass and a back glass, the laminating device comprising:
a heating means (200) for heating the G2G solar module;
a pressing means (300) positioned over the G2G solar module and having a membrane expanding downward to press the G2G solar module; and
at least one support frame (400) installed around the G2G solar module.

9. The laminating device of claim 8, wherein the at least one support frame is installed at all of four edges of the G2G solar module.

10. The laminating device of claim 8, wherein a height of the support frame is equal to or larger than a sum of thicknesses of the front glass and the back glass used for the G2G solar module.

11. The laminating device of claim 8, wherein a height of the support frame is equal to or larger than a thickness of the G2G solar module.

12. The laminating device of claim 8, where a height of the support frame is 1mm larger than a sum of thicknesses of the front glass and the back glass used for the G2G solar module.

13. The laminating device of claim 8, where a height of the support frame is 2mm larger than a sum of thicknesses of the front glass and the back glass used for the G2G solar module.

14. The laminating device of claim 8, wherein a gap between the support frame and an edge of the G2G solar module is 4mm or less.

15. The laminating device of claim 8, further comprising:
a feeder for transporting the G2G solar module to a laminating position; and
a support frame moving means to move the support frame not to disturb transportation of the G2G solar module in a path where the G2G solar module is transported by the feeder.
